(19) Europäisches Patentamt
European Patent Office
Office européen des brevets

(11) Publication number: 0 336 372 B1

(12) EUROPEAN PATENT SPECIFICATION

(45) Date of publication of patent specification: 02.03.94

(51) Int. Cl.[5]: C08F 20/22, C08F 20/38, C09D 133/16, H01L 21/312

(21) Application number: 89105888.5

(22) Date of filing: 04.04.89

# (54) Moistureproof coating.

(30) Priority: 08.04.88 JP 87730/88

(43) Date of publication of application: 11.10.89 Bulletin 89/41

(45) Publication of the grant of the patent: 02.03.94 Bulletin 94/09

(84) Designated Contracting States: DE FR GB

(56) References cited:
EP-A- 0 186 033
US-A- 4 698 240

(73) Proprietor: DAIKIN INDUSTRIES, LIMITED
Umeda Center Building,
4-12, Nakazaki-nishi 2-chome,
Kita-ku
Osaka-shi, Osaka-fu(JP)

(72) Inventor: Inukai, Hiroshi
8-11-710, Showaen
Settsu-shi Osaka-fu(JP)
Inventor: Kitahara, Takahiro
C-22 101, 1-ban
Tsukumodai 2-chome
Suita-shi Osaka-fu(JP)
Inventor: Ueda, Akihiko
3-10-3, Matsu
Nishinari-ku
Osaka-shi Osaka-fu(JP)
Inventor: Tamaru, Shinji
31-10, Senriyamanishi 3-chome
Suita-shi Osaka-fu(JP)

(74) Representative: Schüler, Horst, Dr.
Patentanwalt,
Kaiserstrasse 69
D-60329 Frankfurt (DE)

EP 0 336 372 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to the use as moistureproof coating agent of a composition comprising a photopolymerisation initiator and a fluorinecontaining acrylate represented by the formula

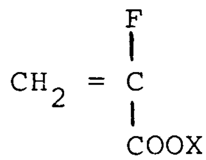

Wherein X is a fluorine containing organic group.

## BACKGROUND OF THE INVENTION

It has already been known to use fluorinecontaining acrylates represented by the formula

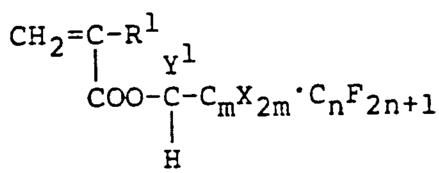

wherein $R^1$ is hydrogen or methyl, X and $Y^1$ are each hydrogen, fluorine, chlorine or bromine, m is 1 to 9, and n is 2 to 9 as moistureproof coating agents for printed boards (U.S. Patent No.3,931,454). However, the coatings prepared from the fluorine-containing acrylates have the drawback of exhibiting poor adhesion to boards.

To overcome the above drawback, it is proposed to use a copolymer of such a fluorine-containing acrylate and a hydrocarbon acrylate as a moistureproof coating agent (U.S. Patent No.4,698,240). Nevertheless, the proposed coating agent has the drawback of being poor in leveling property and film forming property. Accordingly, the coatings obtained by applying the agent to printed boards and drying the applied agent are likely to foam, crack, have variations in thickness or exhibit irregularities when applied. These problems can be alleviated by decreasing the proportion of the copolymerised fluorine-containing acrylate to not greater than one half of the copolymer, but the agent then fails to exhibit moistureproofeness.

## SUMMARY OF THE INVENTION

An object of the present invention is to provide a moistureproof coating composition exhibiting excellent adhesion to the substrate to be protected.

Another object of the invention is to provide a moistureproof coating composition which is excellent in leveling property and film forming property.

Other objects and features of the invention will become apparent from the following description.

The present invention relates to the use as moistureproof coating agent of a composition comprising a photopolymerisation initiator and a fluorine-containing acrylate represented by the formula

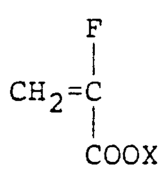

(1)

wherein X is a fluorine-containing organic group.

(2) A moistureproof coating composition (hereinafter referred to as "composition B") comprising a copolymer containing a structural unit represented by the formula

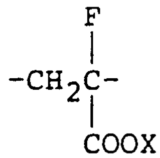

(1')

wherein X is as defined above.

We have conducted intensive research in view of the foregoing problems of the prior art and consequently found that moistureproof coating compositions comprising an α-F-acrylate or a polymer consisting essentially of the acrylate exhibit excellent adhesion to substrates, are therefore capable of giving high moistureproofness to semiconductors, electronic parts and are also excellent in leveling property and film forming property. The present invention has been accomplished base on this novel finding.

## DETAILED DESCRIPTION OF THE INVENTION

The composition A of the invention comprises an α-F-acrylate of the formula (1) as the component capable of forming moistureproof coating films (hereinafter referred to as the "moistureproof coating component"). More specific examples of such α-F-acrylates are fluorine-containing acrylates represented by the following formula (2).

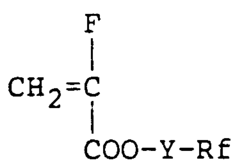

(2)

wherein Y is alkylene having 1 to 3 carbon atoms, a group $-CH_2CH_2N(R)SO_2-$ (wherein R is alkyl having 1 to 4 carbon atoms) or a group $-CH_2CH(OZ)CH_2-$ (wherein Z is a hydrogen atom or acetyl), and Rf is fluoroalkyl having 6 to 29 carbon atoms or fluoroalkyl having 5 to 20 carbon atoms and containing 1 to 10 oxygen atoms in the carbon ring (provided that the oxygen atoms are not present adjacent to one another).

With reference to the formula (2), examples of fluoroalkyl groups represented by Rf and having 6 to 29 carbon atoms or those represented by Rf and having 5 to 29 carbon atoms and containing 1 to 10 oxygen atoms in the carbon ring (provided that the oxygen atoms are not present adjacent to one another) are groups represented by the formula

$-(CF_2CF_2)_mCF(R')CF_3$

wherein m is an integer of 1 to 6, and R' is a fluorine atom or trifluoromethyl, groups represented by the formula

$-[(CF_2)_nO]_qCF(R')CF_3$

wherein R′ is as defined above, n is an integer of 1 to 3, and g is an integer of 1 to 5, groups represented by the formula

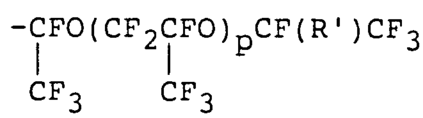

wherein R′ is as defined above, and p is an integer of 0 to 5, and groups represented by the formula

-Ph-O-Rf′

wherein Ph is phenylene, and Rf' is perfluoroalkylene having 5 to 15 carbon atoms.

More specific examples of fluorine-containing acrylates represented by the formula (1) are

$CH_2=CF\text{-}COOCH_2CH_2C_7F_{15}$,

$CH_2=CFCOOCH_2CH_2(CF_2CF_2)_mC_2F_5$ (mixture of compounds wherein m is an integer of 3 to 6),

$CH_2=CF\text{-}COOCH_2C_2F_5$, $CH_2=CF\text{-}COOCH_2C_8F_{16}CF(CF_3)_2$,

$CH_2=CF\text{-}COOCH_2\text{-}CF(CF_3)OCF_2CF(CF_3)OC_3F_7$,

$CH_2=CF\text{-}COOCH_2\text{-}CF(CF_3)OC_3F_7$,

$CH_2=CF\text{-}COOCH_2CH_2\text{-}N\text{-}(CH_3)SO_2C_8F_{17}$, and

$CH_2=CF\text{-}COOCH_2CH(OH)CH_2C_9F_{19}$.

When required, the composition A may contain hydrocarbon (meth)acrylates, (meth)acrylates having a functional group as moistureproof coating components other than the fluorine-containing acrylates (1).

Examples of useful hydrocarbon (meth)acrylates are compounds represented by the formula (3)

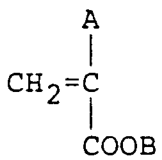

(3)

wherein A is a hydrogen atom, fluorine atom or methyl, and B is alkyl having 1 to 10 carbon atoms, or an alicyclic or aromatic group having 6 to 10 carbon atoms.

More specific examples of such hydrocarbon (meth)acrylates (3) are

$CH_2=CHCOOCH_3$, $CH_2=CHCOOC_{12}H_{25}$,

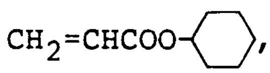,

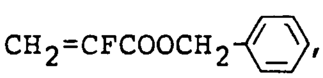, 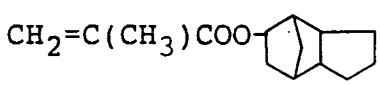,

$CH_2=C(CH_3)COOCH_3$, $CH_2=C(CH_3)COOC_{18}H_{37}$, and

$CH_2=C(CH_3)COOCH_2CH_2C_7H_{15}$.

Examples of (meth)acrylates having a functional group are (meth)acrylates having hydroxyl, carboxyl, glycidyl, dialkylamino, trialkoxysilyl functional group. More specific examples of such compounds are as follows.

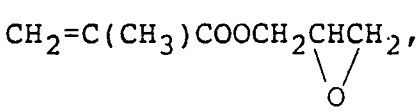,

$CH_2=C(CH_3)COO(CH_2)_3\text{-}Si(OCH_3)_3$

$CH_2=CHCOOCH_2CH_2OH$, $CH_2=CHCOOH$,

$CH_2=CFCOO(CH_2)_3\text{-}Si(OCH_3)_3$

In the case where the fluorine-containing acrylate (1), hydrocarbon (meth)acrylate and (meth)acrylate having a functional group are used in combination as moistureproof coating components, the proportions of these compounds are not limited specifically but can be determined suitably. Usually it is desirable to use 25 to 95 wt.%, preferably 50 to 95 wt.%, of the fluorine-containing acrylate (1), 5 to 75 wt.%, preferably 5 to 50 wt.%, of the hydrocarbon (meth)acrylate (3), and up to 30 wt.%, preferably 0.5 to 20 wt.%, of the (meth)-acrylate having a functional group.

The composition A contains, in addition to the moistureproof coating component or components, a photopolymerization initiator and, when required, a solvent. Examples of useful photopolymerization initiators are those already known, such as benzoyl alkyl ethers, α-hydroxyisobutylphenone and, 1-hydroxycyclohexyl phenyl ketone. The amount of photopolymerization initiator, although not limited specifically, is usually 0.5 to 10 parts by weight, preferably 1 to 5 parts by weight, per 100 parts by weight of the moistureproof coating component.

A moistureproof coating film can be formed on the desired article using the composition A in the same manner as usual coating compositions containing a photopolymerization initiator, for example, by applying the composition A to the article and thereafter irradiating the coating with ultraviolet radiation to polymerize the (meth)acrylate compound present in the composition. The composition can be applied by any known method, for example, by dipping, roll coating, spin coating, spray coating, flow coating or bar coating. Examples of useful ultraviolet radiation sources are a high pressure mercury lamp and metal halide lamp.

The moistureproof coating film to be formed is 0.1 to 150 $\mu$m in thickness. When the thickness is less than 0.1 $\mu$m, the film is likely to have low moistureproofness. Thicknesses exceeding 150 $\mu$m entail an increased cost.

The moistureproof component of the composition B is a fluorine-containing polymer containing at least 25 wt.% of structural units represented by the formula (1′). More specifically, examples of useful fluorine-containing polymers are homopolymers or copolymers of fluorine-containing acrylates (1), copolymers of acrylates (1) and monomers copolymerizable therewith. Examples of useful monomers copolymerizable with acrylates (1) are hydrocarbon (meth)acrylates (3) and (meth)acrylates having a functional group which are exemplified above. Use of the hydrocarbon (meth)acrylate as a monomer component enables the fluorine-containing copolymer obtained to exhibit improved solubility in solvents. Further the (meth)acrylate having a functional group, when used as a polymer component, permits the coating film formed to exhibit enhanced adhesion to the substrate.

The fluorine-containing polymer can be prepared by known radical polymerization processes, for example, by solution polymerization or bulk or mass polymerization.

Examples of solvents usable for solution polymerization are m-xylenehexafluoride, trichloro-trifluoroethane, 1,1,1-trichloroethane, ethyl acetate, methyl isobutyl ketone, acetone, toluene and xylene. Useful polymerization initiators are those already known, such as azobisisobutyronitrile (AIBN) and benzoyl peroxide. Further laurylmercaptan and thiophenol may be used as chain transfer agents. The polymerization temperature is usually 30 to 100 °C.

The solution resulting from solution polymerization and containing the desired fluorine-containing polymer may be used as it is as the composition B. Alternatively, the fluorine-containing polymer may be separated from the solution and dried before use.

Bulk or mass polymerization, when to be resorted to, can be conducted using the same polymerization initiator, chain transfer agent and polymerization conditions as employed for solution polymerization. Preferably, the fluorine-containing polymer obtained by block polymerization is separated from the resulting block and dried before use.

When to be copolymerized, the fluorine-containing acrylate (1), hydrocarbon (meth)acrylate (3) and (meth)acrylate having a functional group can be used in proportions which are not limited sepcifically. Usually, however, it is suitable to use 25 to 95 wt.%, preferably 50 to 95 wt.%, of the fluorine-containing acrylate (1), 75 to 5 wt.%, preferably 50 to 5 wt.%, of the hydrocarbon (meth)acrylate, and up to 30 wt.%, preferably 0.5 to 20 wt.%, of the (meth)acrylate containing a functional group.

Among the fluorine-containing polymers thus obtained, it is desirable to use those having a number average molecular weight of 5,000 to 4,000,000 (as determined by gel permeation chromatography) or those having an intrinsic viscosity [$\eta$] of 0.15 to 3.0 (solvent: m-xylenehexafluoride, methyl ethyl ketone or chloroform or 1,1,1-trichloroethane, temperature: 35 °C). If the molecular weight is too small, the moistureproof coating film is liable to separate from the article treated and is likely to have low strength, whereas if it is excessively great, the composition is not always applicable to articles easily.

The composition B can be prepared by dissolving the moistureproof coating component, i.e. the fluorine-containing polymer, in a suitable solvent. Examples of useful solvents are m-xylenehexafluoride, trichloro-trifluoroethane, tetrachloroethylene, trichloroethylene, trichloroethane, acetone, ethyl acetate, toluene and like aromatic solvents and n-hexane. The diluted composition can be applied by the same method as already described. After application, the composition is dried at room temperature or with heating for 30 minutes to 24 hours, whereby a moistureproof coating film is formed. The concentration of the moistureproof component is suitably determined usually from the range of 0.05 to 40 wt.%, in view of work efficiency. The moistureproof coating film may have the same thickness as is the case with the composition A. When the composition B is to be used, a photo-crosslinking accelerator may be added to the composition B, such that the applied composition is irradiated with ultraviolet radiation to further crosslink the fluorine-containing polymer and to thereby assure the coating of promoted curing.

The moistureproof coating compositions of the present invention can be used generally for applications where moistureproof coating is required. Especially the compositions are favorably usable for printed boards, ICs, LEDs, capacitors and semiconductor parts.

The moistureproof coating compositions of the invention exhibit excellent adhesion to substrates and therefore impart high waterproofness to semiconductors, electronic parts. Since the present compositions are excellent also in leveling property and film forming property, they are usable free of problems such as foaming, cracking, variations in film thickness and irregularities in wetting substrates.

For a better understanding of the invention, examples and comparative examples are given below.

Example 1

Into an ampule were placed 95 g of $CH_2=CFCOOCH_2CH_2C_8F_{17}$, 5 g of $CH_2=CHCOOCH_3$, 1 g of AIBN and 100 g of m-xylenehexafluoride (mXHF), followed by evacuation and intoduction of nitrogen repeatedly and alternately. The ampule was then sealed off and allowed to stand as immersed in a constant-temperature water bath at 50 °C for 24 hours. The reaction mixture was thereafter dissolved in 300 g of 1,1,2-trichloro-1,2,2-trifluoro-ethane (hereinafter referred to as "s-3"), and the solution was placed into 3 liters of methanol for precipitation, giving 99 g of a fluorine-containing copolymer. The copolymer was found to contain 30.5% of C and 60.7% of F by elementary analysis.

NMR revealed that the monomers were copolymerized in the proportions used. The intrinsic viscosity [$\eta$] of the copolymer was measured using Ubbelohde's viscometer and mXHF solution at a temperature of 35 °C. The glass transition temperature (Tg) or melting temperature (Tm) was measured with Model DSC910 of Du Pont Table 1 shows the result.

The fluorine-containing copolymer thus obtained was dissolved in mXHF to a concentration of 10% to prepare a moistureproof coating composition of the invention.

Examples 2-8

The compounds (A.) to (K.) given below were polymerized in various combinations in the same manner as in Example 1 to obtain fluorine-containing polymers each having the composition, Tg or Tm, and intrinsic viscosity [$\eta$] listed in Table 1.

A. $CH_2=CFCOOCH_2CH_2C_8F_{17}$

B. $CH_2=CFCOOCH_3$

C.

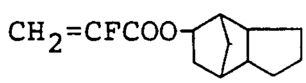

D. $CH_2=CFCOOCH_2CH_2(CF_2)_6\text{-}CF(CF_3)_3$

E. $CH_2=C(CH_3)COOCH_3$

F.

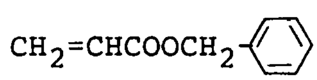

G.

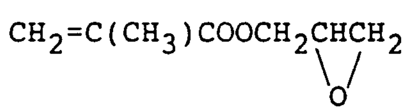

H.

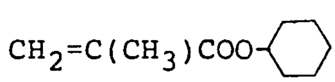

I. $CH_2 = C(CH_3)COOC_2H_5$
J. $CH_2 = CHCOOCH_2CH_2C_8F_{17}$
K. $CH_2 = CHCOOC_{18}H_{32}$

Each of the fluorine-containing polymer obtained was dissolved in a specified solvent (given in Table 1) to a concentration of 15 wt.%. to prepare a moistureproof coating composition of the invention.

Comparative Examples 1 and 2

Using the compounds (J.) and (K.) or the compound (J.) given above, fluorine-containing polymers were obtained in the same manner as in Example 1.

Each of the moistureproof coating compositions prepared in Examples 1 to 9 and Comparative Examples 1 and 2 was applied to an epoxy resin laminate having a glass cloth base and formed with a comblike electrode, I type (conductor width 0.635 mm, conductor spacing 1.27 mm, lap 20.0 mm), prescribed in JIS Z3197, in such an amount that the resulting moistureproof coating film had a predetermined thickness (listed in Table 1) when dried. The coating was dried to prepare a specimen board, which was then allowed to stand in a constant-temperature air chamber (EC126HH3, product of Hitachi, Ltd.) at 65 °C and 85% RH for 800 hours. The specimen board was thereafter checked for the resulting variation in insulation resistance (Ω).

Furthermore, a film 100 μm in thickness, was prepared from each of the composition by casting and checked for moisture permeability ($ml \cdot mm/m^2 \cdot hr \cdot mm\ Hg$) at 40 °C, 90% RH according to JIS Z0208.

Table 1 shows the results obtained.

Comparative Example 3

The same laminate as used in Examples was tested, as untreated, by the same methods as above. Table 1 shows the result.

Table 1

| Ex. | Composition of copolymer (wt. ratio) | Tg or | Intrinsic viscosity [η] | Solvent | Film thick-ness (μm) | Insulation resistance (Ω) Initial value | After 800 hrs. | Moisture permeability (x $10^{-3}$) |
|---|---|---|---|---|---|---|---|---|
| 1 | A./B. (95/5) | 120 | 0.68 | mXHF | 22 | 8 x $10^{13}$ | 6 x $10^{12}$ | 1.5 |
| 2 | A./C. (75/25) | 82 | 0.59 | S-3 | 18 | 2 x $10^{13}$ | 7 x $10^{11}$ | 2.2 |
| 3 | A./E. (75/25) | 85 | 0.58 | S-3 | 25 | 9 x $10^{12}$ | 5 x $10^{11}$ | 3.2 |
| 4 | A./F./G. (67/30/3) | 33 | 0.63 | 1,1,1-Tri-chloroethane | 15 | 1 x $10^{12}$ | 1 x $10^{11}$ | 4.8 |
| 5 | A./H./G. (67/30/3) | 80 | 0.45 | S-3 | 30 | 5 x $10^{12}$ | 2 x $10^{11}$ | 4.3 |
| 6 | D. (100) | 125 | 0.62 | mXHF | 35 | 8 x $10^{13}$ | 2 x $10^{13}$ | 1.0 |
| 7 | A. (75/25) | 65 | 0.38 | mXHF | 25 | 5 x $10^{12}$ | 3 x $10^{11}$ | 3.7 |
| 8 | A./K./G. (67/30/3) | 46 | 0.69 | S-3 | 45 | 1 x $10^{12}$ | 1 x $10^{11}$ | 4.5 |

Table 1 (continued)

| Comp. Ex. | Composition of copolymer (wt. ratio) | Tg or | Intrinsic viscosity [η] | Solvent | Film thickness (μm) | Insulation resistance (Ω) Initial value | After 800 hrs. | Moisture permeability (x $10^{-3}$) |
|---|---|---|---|---|---|---|---|---|
| 1 | J./K. (70/30) | 44 | 0.15 | S-3 | 45 | Note 1) | | 7.2 |
| 2 | J. (100) | 22 | 0.51 | mXHF/S-3 (2/8) | 40 | Note 1) | | Note 1) |
| 3 | J./H. (35/65) | 56 | 0.32 | Ethyle acetate | 28 | 9 x $10^{11}$ | 6 x $10^{9}$ | 7.8 |
| 4 | | Untreated | | | | 1 x $10^{12}$ | 5 x $10^{7}$ | - |

Note 1) The film had uneven thickness, developed many cracks during drying and was not usable for measurement.

The coating films prepared from the compositions of the invention were uniform in thickness and develped no cracks or other irregularities.

Example 9

A moistureproof coating composition of the invention was prepared by thoroughly mixing together 75 g of a mixture of compounds $CH_2=CFCOOCH_2CH_2(CF_2CF_2)_nCF_2CF_3$ (60% for n=3, 30% for n=4 and 10%

of n = 5), 20 g of $CH_2 = CFCOO(CH_2)_3Si(OCH_3)_3$, 5 g of

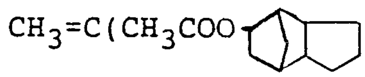

and 3 g of Irgacure 184 (photopolymerization initiator, product of Ciba Geigy).

A glass-epoxy board bearing a comblike electrode was dipped in the composition for 30 seconds, then vertically withdrawn and thereafter irradiated with ultraviolet radiation by a UV irradiator (UI-501C, product of Ushio Denki Co., Ltd.) for 10 minutes on each side, i.e. for 20 minutes in total, to cure the composition. The moistureproof coating film thus prepared was 2 µm in thickness. The board was checked for the variation in insulation resistance (Ω) in the same manner as above. The resistance value was 1 x $10^{12}$ initially and 5 x $10^{11}$ after absorption of moisture.

Example 10

A mixture was prepared from 35 g of $CH = CFCOOCH_2CH_2C_8F_{17}$, 5 g of $CH_2 = CHCOOCH_3$, 10 g of $CH_2 = CFCOO(CH_3)_3Si(OCH_3)_3$, 0.2 g of AIBN and 100 g of mXHF/isopropyl alcohol (IPA) (95/5 in wt.% ratio). The mixture was heated at 50 ° C for polymerization. To the reaction mixture were added 300 g of S-3, 50 g of IPA and 1.5 g of Irgacure 184, and the resulting mixture was thoroughly stirred.

A glass-epoxy board bearing a comblike electrode was dipped in the solution obtained for 30 seconds, then vertically withdrawn and thereafter irradiated with ultraviolet radiation by the UV irradiator (UI-501C, product of Ushio Denki Co., Ltd.) for 10 minutes on each side, i.e. for 20 minutes in total, to crosslink the fluorine-containing polymer obtained by the above polymerization reaction and thereby form a moistureproof coating film, 8 µm in thickness. When the board was checked for the variation in insulation resistance (Ω), the resistance value was 3 x $10^{12}$ initially and 4 x $10^{11}$ after absorption of moisture.

**Claims**

**1.** Use as a moistureproof coating agent of a composition comprising a photopolymerization initiator and a fluorine-containing acrylate represented by the formula

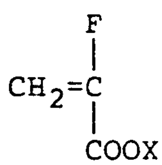

(1)

wherein X is a fluorine-containing organic group.

**2.** Use as a moistureproof coating agent of a composition as defined in claim 1 wherein the fluorine-containing acrylate is a compound represented by the formula

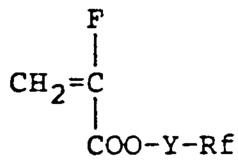

(2)

wherein Y is alkylene having 1 to 3 carbon atoms, a group $-CH_2CH_2N(R)SO_2-$ (wherein R is alkyl having 1 to 4 carbon atoms) or a group $-CH_2CH(OZ)CH_2-$ (wherein Z is a hydrogen atom or acetyl), and Rf is fluoroalkyl having 6 to 29 carbon atoms or fluoroalkyl having 5 to 20 carbon atoms and containing 1 to 10 oxygen atoms in the carbon ring provided that the oxygen atoms are not present adjacent to one another.

3. Use as a moistureproof coating agent of a composition as defined in claim 2 wherein the group represented by Rf in the formula (2) is one of:
a group represented by the formula

$-(CF_2CF_2)_mCF(R')CF_3$

wherein m is an integer of 1 to 6, and R' is a fluorine atom or trifluoromethyl,
a group represented by the formula

$-[(CF_2)_nO]_qCF(R')CF_3$

wherein R' is as defined above, n is a integer of 1 to 3, and q is an integer of 1 to 5,
a group represented by the formula

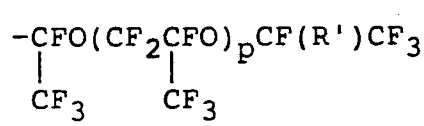

wherein R' is as defined above, and p is an integer of 0 to 5, and
a group represented by the formula

-Ph-O-Rf'

wherein Ph is phenylene, and Rf' is perfluoroalkylene having 5 to 15 carbon atoms.

4. Use as a moistureproof coating agent of a composition as defined in claim 1 which comprises:
100 parts by weight of a moistureproof coating component containing (i) 25 to 95 wt.% of the fluorine-containing acrylate of the formula (1), and 5 to 75 wt.% of a hydrocarbon (meth)acrylate represented by the formula

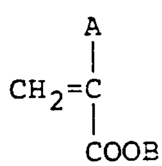

(3)

wherein A is a hydrogen atom, fluorine atom or methyl, and B is alkyl having 1 to 10 carbon atoms or alicyclic or aromatic group having 6 to 10 carbon atoms, and
0.5 to 10 parts by weight of the photopolymerization initiator.

5. Use as a moistureproof coating agent of a composition as defined in claim 4 wherein the fluorine-containing acrylate is a compound represented by the formula

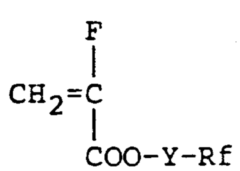

(2)

wherein Y is alkylene having 1 to 3 carbon atoms, a group $-CH_2CH_2N(R)SO_2-$ (wherein R is alkyl having 1 to 4 carbon atoms) or a group $-CH_2CH(OZ)CH_2-$ (wherein Z is a hydrogen atom or acetyl), and Rf is fluoroalkyl having 6 to 29 carbon atoms or fluoroalkyl having 5 to 20 carbon atoms and containing 1 to 10 oxygen atoms in the carbon ring provided that the oxygen atoms are not present adjacent to one another.

6. Use as a moistureproof coating agent of a composition as defined in claim 4 wherein the moistureproof coating component further contains up to 30 wt.% of a (meth)acrylate having a functional group.

7. Use as a moistureproof coating agent of a composition as defined in claim 6 wherein the content of the (meth)acrylate having a functional group is 0.5 to 20 wt.%.

8. Use as a moistureproof coating agent of a composition as defined in claim 1 wherein the amount of the photopolymerization initiator is 0.5 to 10% of the weight of the fluorine-containing acrylate of the formula (1).

9. Use as a moistureproof coating defined in claim 8 wherein the amount of the photopolymerization initiator is 1 to 5% of the weight of the fluorine-containing acrylate of the formula (1).

10. Use as a moistureproof coating agent of a composition comprising a polymer containing a structural unit represented by the formula

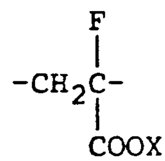

(1')

wherein X is a fluorine-containing organic group.

11. Use as a moistureproof coating agent of a composition as defined in claim 10 wherein the structural unit is a unit represented by the formula

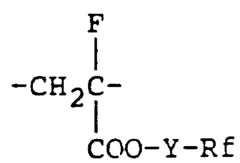

(2')

wherein Y is alkylene having 1 to 3 carbon atoms, a group $-CH_2CH_2N(R)SO_2-$ (wherein R is alkyl having 1 to 4 carbon atoms) or a group $-CH_2CH(OZ)CH_2-$ (wherein Z is a hydrogen atom or acetyl), and Rf is fluoroalkyl having 6 to 29 carbon atoms or fluoroalkyl having 5 to 20 carbon atoms and containing 1 to 10 oxygen atoms in the carbon ring provided that the oxygen atoms are not present adjacent to one another.

12. Use as a moistureproof coating agent of a composition as defined in claim 10 wherein the polymer contains at least 25 wt.% of the structural unit represented by the formula (1').

13. Use as a moistureproof coating agent of a composition as defined in claim 12 which comprises a copolymer containing 25 to 95 wt.% of the structural unit of the formula (2'), and 5 to 75 wt.% of a structural unit represented by the formula

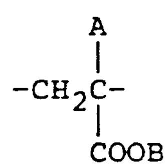

(3')

wherein A is a hydrogen atom, fluorine atom or methyl, and B is alkyl having 1 to 10 carbon atoms or alicyclic or aromatic group having 6 to 10 carbon atoms.

## Patentansprüche

1. Verwendung als ein feuchtigkeitsundurchlässiges Überzugsmittel einer Zusammensetzung, die einen Photopolymerisationsinitiator und ein fluorhaltiges Akrylat umfaßt, das durch die Formel

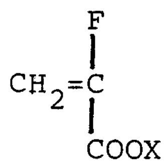

(1)

dargestellt wird, worin X eine fluorhaltige organische Gruppe ist.

2. Verwendung als ein feuchtigkeitsundurchlässiges Überzugsmittel einer Zusammensetzung, wie sie in Anspruch 1 definiert ist, in der das fluorhaltige Akrylat eine Verbindung ist, die durch die Formel

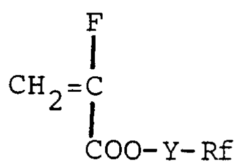

(2)

dargestellt wird, worin Y Alkylen mit 1 bis 3 Kohlenstoffatomen, eine Gruppe $-CH_2CH_2N(R)SO_2-$ (worin R Alkyl mit 1 bis 4 Kohlenstoffatomen ist) oder eine Gruppe $-CH_2CH(OZ)CH_2-$ (worin Z ein Wasserstoffatom oder Acetyl ist) ist und Rf Fluoralkyl mit 6 bis 29 Kohlenstoffatomen oder Fluoralkyl mit 5 bis 20 Kohlenstoffatomen und enthaltend 1 bis 10 Sauerstoffatome in dem Kohlenstoffring ist, vorausgesetzt, daß die Sauerstoffatome nicht zueinander benachbart vorliegen.

3. Verwendung als ein feuchtigkeitsundurchlässiges Überzugsmittel einer Zusammensetzung, wie sie in Anspruch 2 definiert ist, bei der die durch Rf dargestellte Gruppe in der Formel (2) eine von den folgenden ist: eine Gruppe, die durch die Formel

$-(CF_2CF_2)_mCF(R')CF_3$

dargestellt wird, worin m eine ganze Zahl von 1 bis 6 ist und R' ein Fluoratom oder Trifluormethyl ist, eine Gruppe, die durch die Formel

$-[(CF_2)_nO]_qCF(R')CF_3$

dargestellt wird, worin R' so wie vorstehend definiert ist, n eine ganze Zahl von 1 bis 3 ist und q eine ganze Zahl von 1 bis 5 ist,
eine Gruppe, die durch die Formel

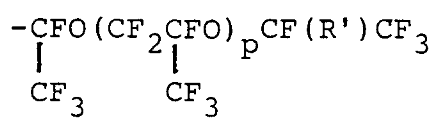

dargestellt wird, worin R' so wie oben definiert ist und p eine ganze Zahl von 0 bis 5 ist, und eine Gruppe, die durch die Formel

-Ph-O-Rf'

dargestellt wird, worin Ph Phenylen ist und Rf' Perfluoralkylen mit 5 bis 15 Kohlenstoffatomen ist.

**4.** Verwendung als ein feuchtigkeitsundurchlässiges Überzugsmittel einer Zusammensetzung, wie sie in Anspruch 1 definiert ist, die folgendes umfaßt:
100 Gewichtsteile einer feuchtigkeitsundurchlässigen Beschichtungskomponente, die (i) 25 bis 95 Gewichts-% des fluorhaltigen Akrylats der Formel (1) und 5 bis 75 Gewichts-% eines Kohlenwasserstoff(meth)akrylats enthält, welches durch die Formel

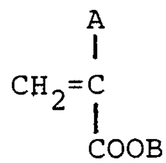

(3)

dargestellt wird, worin A ein Wasserstoffatom, Fluoratom oder Methyl ist und B Alkyl mit 1 bis 10 Kohlenstoffatomen oder eine alizyklische oder aromatische Gruppe mit 6 bis 10 Kohlenstoffatomen ist, und 0,5 bis 10 Gewichtsteile des Photopolymerisationsinitiators.

**5.** Verwendung als ein feuchtigkeitsundurchlässiges Überzugsmittel einer Zusammensetzung, wie sie in Anspruch 4 definiert ist, bei der das fluorhaltige Akrylat eine Verbindung ist, die durch die Formel

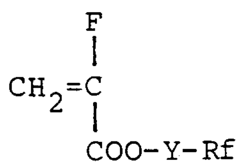

(2)

dargestellt wird, worin Y Alkylen mit 1 bis 3 Kohlenstoffatomen, eine Gruppe $-CH_2CH_2N(R)SO_2-$ (worin R Alkyl mit 1 bis 4 Kohlenstoffatomen ist) oder eine Gruppe $-CH_2CH(OZ)CH_2-$ (worin Z ein Wasserstoffatom oder Acetyl ist) ist und Rf Fluoralkyl mit 6 bis 29 Kohlenstoffatomen oder Fluoralkyl mit 5 bis 20 Kohlenstoffatomen und enthaltend 1 bis 10 Sauerstoffatome in dem Kohlenstoffring unter der Voraussetzung ist, daß die Sauerstoffatome nicht einander benachbart vorliegen.

**6.** Verwendung als ein feuchtigkeitsundurchlässiges Überzugsmittel einer Zusammensetzung, wie sie in Anspruch 4 definiert ist, wobei die feuchtigkeitsundurchlässige Überzugskomponente weiterhin bis zu 30 Gewichts-% eines (Meth)akrylats mit einer funktionellen Gruppe enthält.

**7.** Verwendung als ein feuchtigkeitsundurchlässiges Überzugsmittel einer Zusammensetzung, wie sie in Anspruch 6 definiert ist, bei der der Gehalt des (Meth)akrylats mit einer funktionellen Gruppe 0,5 bis 20 Gewichts-% ist.

**8.** Verwendung als ein feuchtigkeitsundurchlässiges Überzugsmittel einer Zusammensetzung, wie sie in Anspruch 1 definiert ist, bei der die Menge des Photopolymerisationsinitiators 0,5 bis 10 Gewichts-% des fluorhaltigen Akrylats der Formel (1) beträgt.

**9.** Verwendung als ein feuchtigkeitsundurchlässiges Überzugsmittel, wie es in Anspruch 8 definiert ist, wobei die Menge des Photopolymerisationsinitiators 1 bis 5 Gewichts-% des fluorhaltigen Akrylats der Formel (1) ist.

**10.** Verwendung als ein feuchtigkeitsundurchlässiges Überzugsmittel einer Zusammensetzung, die ein Polymer umfaßt, das eine Struktureinheit enthält, die durch die Formel

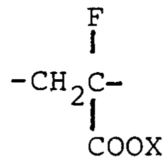

(1')

dargestellt wird, worin X eine fluorhaltige organische Gruppe ist.

**11.** Verwendung als ein feuchtigkeitsundurchlässiges Überzugsmittel einer Zusammensetzung, wie sie in Anspruch 10 definiert ist, wobei die Struktureinheit eine Einheit ist, die durch die Formel

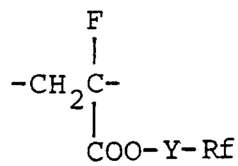

(2')

dargestellt wird, worin Y Alkylen mit 1 bis 3 Kohlenstoffatomen, eine Gruppe $-CH_2CH_2N(R)SO_2-$ (worin R Alkyl mit 1 bis 4 Kohlenstoffatomen ist) oder eine Gruppe $-CH_2CH(OZ)CH_2-$ (worin Z ein Wasserstoffatom oder Acetyl ist) ist und Rf Fluoralkyl mit 6 bis 29 Kohlenstoffatomen oder Fluoralkyl mit 5 bis 20 Kohlenstoffatomen und enthaltend 1 bis 10 Sauerstoffatome in dem Kohlenstoffring unter der Voraussetzung ist, daß die Sauerstoffatome nicht einander benachbart vorhanden sind.

**12.** Verwendung als ein feuchtigkeitsundurchlässiges Überzugsmittel einer Zusammensetzung, wie sie in Anspruch 10 definiert ist, wobei das Polymer wenigstens 25 Gewichts-% der Struktureinheit enthält, die durch die Formel (1') dargestellt wird.

**13.** Verwendung als ein feuchtigkeitsundurchlässiges Überzugsmittel einer Zusammensetzung, wie sie in Anspruch 12 definiert ist, die ein Copolymer umfaßt, das 25 bis 95 Gewichts-% der Struktureinheit gemäß Formel (2') und 5 bis 75 Gewichts-% einer Struktureinheit enthält, die durch die Formel

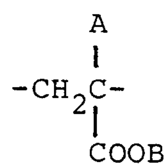

(3')

dargestellt wird, worin A ein Wasserstoffatom, Fluoratom oder Methyl ist und B Alkyl mit 1 bis 10 Kohlenstoffatomen oder eine alizyklische oder aromatische Gruppe mit 6 bis 10 Kohlenstoffatomen ist.

## Revendications

**1.** Utilisation en tant qu'agent de revêtement imperméable à l'humidité, d'une composition comprenant un initiateur de photopolymérisation et un acrylate contenant du fluor, représenté par la formule :

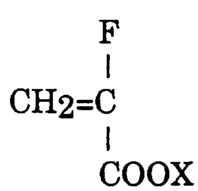

(1)

dans laquelle X est un groupe organique contenant du fluor.

**2.** Utilisation en tant qu'agent de revêtement imperméable à l'humidité, d'une composition telle que définie dans la revendication 1, dans laquelle l'acrylate contenant du fluor est un composé représenté par la formule :

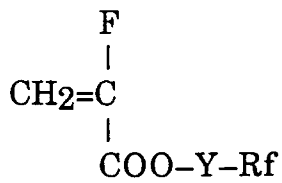

(2)

dans laquelle Y est un groupe alkylène ayant 1 à 3 atomes de carbone, un groupe $-CH_2CH_2N(R)SO_2-$ (dans lequel R est un groupe alkyle ayant 1 à 4 atomes de carbone) ou un groupe $-CH_2CH(OZ)CH_2-$ (dans lequel Z est un atome d'hydrogène ou un groupe acétyle) et Rf est un groupe fluoroalkyle ayant 6 à 29 atomes de carbone ou fluoroalkyle ayant 5 à 20 atomes de carbone et contenant 1 à 10 atomes d'oxygène dans le cycle carboné à condition que les atomes d'oxygène ne soient adjacents l'un avec l'autre.

**3.** Utilisation en tant qu'agent de revêtement imperméable à l'humidité, d'une composition telle que définie dans la revendication 2, dans laquelle le groupe représenté par Rf dans la formule (2) est un groupe parmi :

un groupe représenté par la formule

$-(CF_2CF_2)_mCF(R')CF_3$

dans laquelle m est un entier de 1 à 6, et R' est un atome de fluor ou un groupe trifluorométhyle,

un groupe représenté par la formule

$-[(CF_2)_nO]_qCF(R')CF_3$

dans laquelle R' est tel que défini plus haut, n est un entier de 1 à 3 et s est un entier de 1 à 5,

un groupe représenté par la formule

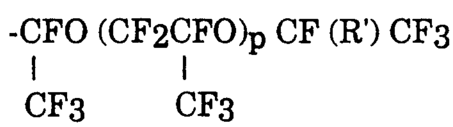

dans laquelle R' est tel que défini plus haut, et p est un entier de 0 à 5,

et un groupe représenté par la formule

-Ph-O-Rf'

dans laquelle Ph est un groupe phénylène et Rf' est un groupe perfluoroalkylène ayant 5 à 15 atomes de carbone.

**4.** Utilisation en tant qu'agent de revêtement imperméable à l'humidité, d'une composition telle que définie dans la revendication 1, qui comprend :

100 parties en poids d'un composant de revêtement imperméable à l'humidité contenant (i) 25 à 95% en poids de l'acrylate contenant du fluor de formule (1) et 5 à 75% en poids d'un (méth)acrylate d'hydrocarbure représenté par la formule :

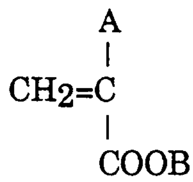

(3)

dans laquelle A est un atome d'hydrogène ou de fluor, ou un groupe méthyle, et B est un groupe alkyle ayant 1 à 10 atomes de carbone ou un groupe alicyclique ou aromatique ayant 6 à 10 atomes de carbone, et

0,5 à 10 parties en poids de l'initiateur de photopolymérisation.

**5.** Utilisation en tant qu'agent de revêtement imperméable à l'humidité, d'une composition telle que définie dans la revendication 4, dans laquelle l'acrylate contenant du fluor est un composé représenté par la formule :

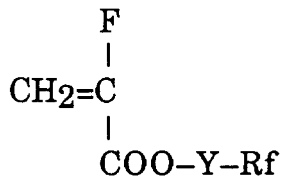

(2)

dans laquelle Y est un groupe alkylène ayant 1 à 3 atomes de carbone, un groupe $-CH_2CH_2N(R)SO_2-$ (dans lequel R est un groupe alkyle ayant 1 à 4 atomes de carbone) ou un groupe $-CH_2CH(OZ)CH_2-$ (dans lequel Z est un atome d'hydrogène ou un groupe acétyle) et Rf est un groupe fluoroalkyle ayant 6 à 29 atomes de carbone ou fluoroalkyle ayant 5 à 20 atomes de carbone et contenant 1 à 10 atomes d'oxygène dans le cycle carboné à condition que les atomes d'oxygène ne soient adjacents l'un avec l'autre.

**6.** Utilisation en tant qu'agent de revêtement imperméable à l'humidité, d'une composition telle que définie dans la revendication 4, dans laquelle le composant de revêtement imperméable à l'humidité comprend de plus jusqu'à 30% en poids d'un (méth)acrylate ayant un groupe fonctionnel.

**7.** Utilisation en tant qu'agent de revêtement imperméable à l'humidité, d'une composition telle que définie dans la revendication 6, dans laquelle la teneur en (méth)acrylate ayant un groupe fonctionnel est de 0,5 à 20% en poids.

**8.** Utilisation en tant qu'agent de revêtement imperméable à l'humidité, d'une composition telle que définie dans la revendication 1, dans laquelle la quantité de l'initiateur de photopolymérisation est de 0,5 à 10% du poids de l'acrylate contenant du fluor de formule (1).

**9.** Utilisation en tant qu'agent de revêtement imperméable à l'humidité, d'une composition telle que définie dans la revendication 8, dans laquelle la quantité de l'initiateur de photopolymérisation est de 1 à 5% du poids de l'acrylate contenant du fluor de formule (1).

**10.** Utilisation en tant qu'agent de revêtement imperméable à l'humidité, d'une composition comprenant un polymère contenant une unité structurale représentée par la formule :

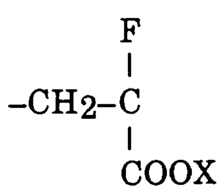

(1')

dans laquelle X est un groupe organique contenant du fluor.

**11.** Utilisation en tant qu'agent de revêtement imperméable à l'humidité, d'une composition telle que définie dans la revendication 10, dans laquelle l'unité structurale est une unité représentée par la formule :

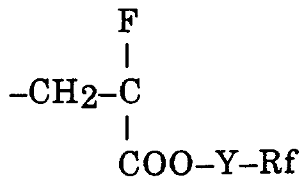

(2')

dans laquelle Y est un groupe alkylène ayant 1 à 3 atomes de carbone, un groupe $-CH_2CH_2N(R)SO_2-$ (dans lequel R est un groupe alkyle ayant 1 à 4 atomes de carbone) ou un groupe $-CH_2CH(OZ)CH_2-$ (dans lequel Z est un atome d'hydrogène ou un groupe acétyle) et Rf est un groupe fluoroalkyle ayant 6 à 29 atomes de carbone ou fluoroalkyle ayant 5 à 20 atomes de carbone et contenant 1 à 10 atomes d'oxygène dans le cycle carboné à condition que les atomes d'oxygène ne soient adjacents l'un avec l'autre.

**12.** Utilisation en tant qu'agent de revêtement imperméable à l'humidité, d'une composition telle que définie dans la revendication 10 dans laquelle le polymère contient au moins 25% en poids de l'unité structurale représentée par la formule (1').

**13.** Utilisation en tant qu'agent de revêtement imperméable à l'humidité, d'une composition telle que définie dans la revendication 12 qui comprend un polymère contenant 25% à 95% en poids de l'unité structurale représentée par la formule (2') et 5 à 75% en poids d'une unité structurale représentée par la formule :

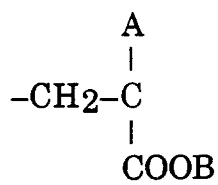

(3')

dans laquelle A est un atome d'hydrogène ou de fluor, ou un groupe méthyle, et B est un groupe alkyle ayant 1 à 10 atomes de carbone ou un groupe alicyclique ou aromatique ayant 6 à 10 atomes de carbone.